# EUROPÄISCHE PATENTSCHRIFT

(11) **EP 2 164 314 B1**
(45) Veröffentlichungstag und Bekanntmachung des Hinweises auf die Patenterteilung: **19.11.2014**
(21) Anmeldenummer: 08016315.7
(22) Anmeldetag: 16.09.2008
(51) Int. Cl.: H05K 5/00, H02K 5/22, H02K 11/00, H05K 7/14

(54) **Klemmenkasten zum elektrischen Anschluss an einen Elektromotor**
Clamp cabinet for electrically connecting to an electric motor
Coffret à bornes destiné au raccordement électrique sur un moteur électrique

(43) Veröffentlichungstag der Anmeldung: 17.03.2010
(73) Patentinhaber: Grundfos Management A/S, 8850 Bjerringbro (DK)
(72) Erfinder: Ellegaard, Jorgen, 8680 Ry (DK)
(74) Vertreter: Hemmer, Arnd

(56) Entgegenhaltungen:
- EP-A- 1 659 837
- EP-A1- 1 578 004
- WO-A-97/16883
- WO-A-2005/028834
- DE-A1- 10 162 405
- DE-A1- 19 953 191
- DE-A1-102005 042 696
- DE-A1-102006 025 977
- GB-A- 2 336 254
- US-A1- 2003 039 107
- US-B1- 6 317 332
- US-B1- 6 642 633
- US-B1- 6 896 536

## Beschreibung

Die Erfindung betrifft einen Klemmenkasten zum elektrischen Anschluss an einen Elektromotor, insbesondere einer Umwälzpumpe, gemäß dem Oberbegriff des Patentanspruchs 1, ein Klemmenkastensystem mit einem solchen Klemmenkasten sowie ein Pumpenaggregat.

Zum elektrischen Anschluss von Elektromotoren, insbesondere Elektromotoren von Umwälzpumpen, sind üblicherweise Klemmenkästen vorgesehen. In diesen können zusätzlich zu den reinen Anschlusselementen weitere elektronische Bauteile zur Steuerung des Elektromotors angeordnet sein. Je nach Funktionsumfang können darüber hinaus auch Bauteile oder Schnittstellen zur Kommunikation oder Steuerung weiterer Aggregate im Klemmenkasten angeordnet sein.

US 2003/0039107 A1 offenbart eine elektrische Schalteinrichtung bzw. ein elektrisches Betätigungsglied mit einer im Inneren eines Gehäuses angeordneten Leiterplatte, welche sich parallel zur Grundfläche des Gehäuses erstreckt. An der Leiterplatte sind senkrecht zu der Leiterplatte vorstehend elektrische Kontaktelemente ausgebildet, in welche Anschlussstifte elektrischer Bauteile, wie beispielsweise Relais eingreifen können. Dabei sind die elektrischen Bauteile außerhalb des Gehäuses angeordnet und erstrecken sich mit ihren Anschlussstiften durch Öffnungen des Gehäuses. Eine solche Anordnung elektrischer Bauteile ist für einen Klemmenkasten, wie er zum elektrischen Anschluss eines Elektromotors einer Pumpe Verwendung findet, gänzlich ungeeignet, da die elektrischen Verbindungen und die Öffnungen im Gehäuse nur schlecht vor eindringender Feuchtigkeit zu schützen sind.

DE 101 62 405 A1 offenbart eine Steckverbindung, welche der elektrischen Verbindung eines Kabels mit einem Elektronikmodul dient. Das Modul weist eine im Inneren eines Gehäuses angeordnete Leiterplatte auf. Am Rand der Leiterplatte sind elektrische Kontaktflächen ausgebildet, welche einer Öffnung des Gehäuses zugewandt sind. Durch die Öffnung des Gehäuses kann ein Stecker in das Gehäuse so eingesteckt werden, dass er mit elektrischen Kontaktelementen direkt die Kontaktflächen der Leiterplatte kontaktiert.

US 6,317,332 B1 offenbart ein Elektronikmodul zur Verbindung mit einem Antriebsmotor. Dieses Elektronikmodul weist ein Gehäuse auf, welches einen Verbindungsstecker zur Verbindung mit dem Antriebsmotor und einen Anschlussstecker zum Anschluss einer elektrischen Anschlussleitung aufweist. Im Inneren des Gehäuses sind elektrische Leiterbahnen angeordnet, welche in sich senkrecht zur Gehäusegrundfläche erstreckenden Kontaktelementen enden. Diese greifen in Löcher einer sich normal zu den Anschlusselementen erstreckenden Leiterplatte ein und können dort mit Leiterbahnen auf der Leiterplatte verlötet sein. Die Montage und Verbindung einer Leiterplatte mit solchen Kontaktelementen ist aufgrund der erforderlichen Lötverbindung recht aufwendig. Darüber hinaus ist eine aufwendige Formgebung der Kontaktelemente und elektrischen Leiter im Inneren des Gehäuses erforderlich.

DE 10 2006 025 977 A1 offenbart ein Steuergerät zur Verwendung in einem Kraftfahrzeug. Dieses Steuergerät weist ein Gehäuse mit einer darin angeordneten Leiterplatte auf. Die Leiterplatte weist an ihren Seitenkanten ausgebildete elektrische Kontakte auf, welche mit elektrischen Kontaktzungen in Kontakt treten, welche an einer gegenüberliegenden Gehäusewandung angeordnet sind. Dabei sind die Kontaktzungen an einer Gehäusewandung angeordnet, welche sich normal zu der Leiterplatte erstreckt, das heißt die Kontaktzungen erstrecken sich im Wesentlichen parallel zu der Gehäusewandung, sodass die Leiterplatte parallel zu dieser Gehäusewandung in das Gehäuse eingesetzt werden kann. Im Gehäuse wird die Leiterplatte über Stifte fixiert, sodass die Leiterplatte mit ihren Kanten in Anlage an den Kontaktzungen gehalten wird. Eine zusätzliche Fixierung der Leiterplatte ist erforderlich, um die relativ kleinen Kontaktflächen an den Stirnkanten der Leiterplatten in sicherer Anlage mit den Kontaktzungen zu halten.

Es ist Aufgabe der Erfindung, einem Klemmenkasten zum elektrischen Anschluss an einem Elektromotor, insbesondere eine Umwälzpumpe zu schaffen, welcher einfach und kostengünstig hergestellt und aufgebaut werden kann und darüber hinaus auf einfache Weise eine sichere Kontaktierung und Befestigung einer Leiterplatte im Inneren ermöglicht. Darüber hinaus ist es Aufgabe der Erfindung, ein Pumpenaggregat mit einem derart verbesserten Klemmenkasten zu schaffen.

Diese Aufgabe wird durch einen Klemmenkasten mit den in Anspruch 1 angegebenen Merkmalen, durch Klemmenkastensysteme mit den in den Ansprüchen 13 und 14 angegebenen Merkmalen sowie durch ein Pumpenaggregat mit den in Anspruch 15 angegebenen Merkmalen gelöst. Vorteilhafte Ausgestaltungen ergeben sich aus den Unteransprüchen, der Beschreibung sowie den Figuren.

Der erfindungsgemäße Klemmenkasten ist zum elektrischen Anschluss an einen Elektromotor, insbesondere einer Umwälzpumpe, vorgesehen. Der Klemmenkasten umfasst zumindest eine Wandung und zumindest eine Leiterplatte. Vorzugsweise bildet dabei die Wandung einen Teil des Gehäuses des Klemmenkastens. Grundsätzlich kann die Wandung jedoch auch Teil eines in das Gehäuse eingebrachten Bauteils sein, bei welchem die Wandung zum Gehäuse insbesondere ortsfest angeordnet ist. Der Klemmenkasten weist an der Wandung zumindest einen elektrischen Kontakt zur Verbindung mit der Leiterplatte auf, welcher als Klemmelement zur lösbaren Klemmung der mit ihren Flachseiten senkrecht zu dieser Wandung orientierten Leiterplatte ausgebildet ist. Eine Leiterplatte im Sinne dieser Erfindung kann dabei elektrische oder elektronische Bauteile, beispielsweise zur Steuerung und/oder zur Überwachung des Elektromotors tragen. Mit dem als Klemmelement ausgebildeten elektrischen Kontakt ist die Leiterplatte besonders einfach im erfindungsgemäßen Klemmenkasten montierbar. Zudem ist die Leiterplatte gleichzeitig mit der Montage und daher besonders einfach elektrisch kontaktierbar. Auf diese Weise muss die Leiterplatte nicht in einem eigenen Montageschritt elektrisch kontaktiert werden. Vielmehr erfolgen elektrische Kontaktierung und mechanische Fixierung in einem einzigen Montageschritt, indem die Leiterplatte in das Klemmelement eingesetzt wird. Damit kann ein Montageschritt beim Aufbau des Klemmenkastens eingespart werden. Die lösbare Klemmung der Leiterplatte erlaubt ferner einen einfachen Austausch der Leiterplatte, da mit dem Lösen der Leiterplatte aus ihrer Klemmung auch ihre elektrische Kontaktierung einfach und reversibel unterbrochen wird. Bei dem zuvor genannten elektrischen Kontakt muss es sich nicht notwendigerweise um einen einzelnen elektrischen Kontakt handeln. Vielmehr kann der elektrische Kontakt im Sinne dieser Erfindung auch ein Kontaktfeld mit einer Vielzahl elektrischer Kontakte umfassen.

Bevorzugt ist die Leiterplatte nicht allein in einer mit ihren Flachseiten zur Wandung senkrechten Orientierung geklemmt, sondern auch mit ihren Flachseiten senkrecht zur Wandung orientiert in ihre Klemmposition schiebbar. Eine derartige Ausgestaltung vereinfacht deutlich die Montage des Klemmenkastens, da lediglich eine lineare, auf die Wandung zugerichtete Bewegung der Leiterplatte erforderlich ist. Ähnlich einfach gestaltet sich auch ein Lösen der Leiterplatte aus dem Klemmenkasten für einen Austausch der Leiterplatte. Besonders vorteilhaft ist eine solche Ausgestaltung bei Klemmenkastensystemen, wie sie nachfolgend beschrieben sind.

Erfindungsgemäß ist bei dem Klemmenkasten das Klemmelement als ein Paar federnder Klemmzungen ausgebildet, welche sich senkrecht von der Wandung forterstrecken, und mittels welchen die Leiterplatten an ihren Flachseiten geklemmt ist. Dabei ist unter einer sich senkrecht zur Wandung erstreckenden Klemmzunge zu verstehen, dass sie eine im Wesentlichen senkrecht zur Wandung orientierte federnde Lasche umfasst. Dabei können die Klemmzungen auch Vorsprünge, insbesondere an von der Wandung beabstandeten Abschnitten, an den federnden Laschen umfassen, die bei Klemmung einer Leiterplatte beispielsweise senkrecht auf die Flachseiten der Leiterplatte zu gerichtet sind. Vorzugsweise liegen die Klemmzungen einander gegenüber, sodass die Leiterplatte zwischen beiden Klemmzungen klemmbar ist. Vorteilhaft kann eine Leiterplatte in dieser Ausgestaltung senkrecht auf die Wandung zu zwischen die Klemmzungen in ihre Klemmposition bewegt werden, sodass lediglich eine lineare Bewegung erforderlich ist, um die Leiterplatte im Klemmenkasten anzuordnen.

Vorzugsweise weist bei dem Klemmenkasten die Leiterplatte auf zumindest einer ihre Flachseiten zumindest einen elektrischen Kontakt zu Verbindung mit dem Klemmelement auf, welcher nahe einer Seitenkante der Leiterplatte angeordnet ist. In einer solchen Ausgestaltung kann der zumindest eine elektrische Kontakt an der Leiterplatte als Teil einer auf einer Flachseite der Leiterplatte verlaufenden Leiterbahn ausgebildet sein. Diese Ausgestaltung ermöglicht eine besonders einfache Herstellung der Leiterplatte. Bevorzugt ist dabei der zumindest eine elektrische Kontakt als flächiger Kontakt ausgebildet. Korrespondierend dazu weist das Paar federnder Klemmzungen zumindest einen Kontaktbereich auf, der beispielsweise als plane Kontaktfläche oder als ein- oder zweiseitig gekrümmte Kontaktfläche, beispielsweise als Vorsprung, ausgestaltet sein kann. Auf diese Weise lässt sich ein Flächen-, Linien- oder Punktkontakt zur elektrischen Kontaktierung der Leiterplatte realisieren.

Bevorzugt ist bei dem Klemmenkasten das Klemmelement in das Gehäuse des Klemmenkastens eingegossen. Auf diese Weise kann der Klemmenkasten besonders einfach und kostengünstig gefertigt werden, da das Klemmelement nicht in einem eigens vorzusehenden Fertigungsschritt an dem Gehäuse positioniert und fixiert werden muss. Vielmehr können die Fertigung des Gehäuses und die Anordnung des Klemmelementes an dem Gehäuse in einem einzigen Fertigungsschritt erfolgen, in dem das Klemmelement bei der Fertigung des Gehäuses umgossen bzw, umspritzt wird. Dazu ist das Gehäuse zweckmaßigerweise aus Kunststoff und als Spritzgussteil gefertigt. Dabei ist es nicht erforderlich, dass das gesamte Gehäuse aus Kunststoff bzw. als Spritzgussteil gefertigt ist. Das Spritzgussteil kann dabei zum Beispiel lediglich einen Teil des Gehäuses des Klemmenkastens bilden, welcher den Bereich der Wandung umfasst, an dem das Klemmelement angeordnet ist.

Weiter bevorzugt ist bei dem Klemmenkasten das Klemmelement Teil eines Leiterbahnsystems, welches in das Gehäuse bzw. ein erstes Gehäuseteil des Klemmenkastens eingegossen ist. Auf diese Weise ist bei der Herstellung des Klemmenkastens eine elektrische Kontaktierung des Klemmelementes in einem weiteren Fertigungsschritt entbehrlich.

In einer besonders bevorzugten Ausgestaltung weist das Leiterbahnsystem zumindest eine der nachfolgenden Komponenten auf: einen elektrischen Steckkontaktbereich zum Anschluss des Elektromotors, einen elektrischen Steckkontaktbereich zum Anschluss an eine Spannungsquelle, einen feststehenden elektrischen Kontakt eines Bedienschalters, einen elektrischen Kontakt zum Anschluss eines Kondensators, ein Erdungselement. Idealerweise sind sämtliche elektrischen Verbindungen und Kontakte des Klemmenkastens in das Gehäuse eingegossen. So kann auf eine aufwendige Verdrahtung oder zusätzliche Leiterplatten mit den erforderlichen elektrischen Verbindungen verzichtet werden. Ferner bevorzugt handelt es sich bei dem elektrischen Kontakt eines Bedienschalters um einen solchen Kontakt. eines Bedienschalters, wie er nachfolgend beschrieben ist.

Vorzugsweise weist der Klemmenkasten eine Haltevorrichtung zur Klemmung eines Kondensators auf, welche aus einem elastischen Kunststoff ausgebildet ist. In dieser Ausgestaltung kann ein aus Kunststoff gegossener Klemmenkasten gemeinsam mit der Haltevorrichtung zur Klemmung eines Kondensators im Mehrkomponenten-Spritzgleßen gefertigt sein, wobei das Gehäuse eine erste Komponente und die Haltevorrichtung eine zweite Komponente eines Mehrkomponehten-Spritzgussteils bildet. Allerdings ist es auch möglich, die Haltevorrichtung als separates Bauteil in eine entsprechende Aufnahme in den Klemmenkasten einzusetzen.

Weiter bevorzugt weist der Klemmenkasten zudem einen ersten Gehäuseteil und einen von diesem lösbaren Deckel mit einer zwischenliegenden Dichtung auf, wobei die Dichtung und die Haltevorrichtung aus demselben Material und gemeinsam mit dem ersten Gehäuseteil des Klemmenkastens als Mehrkomponenten-Spritzgussteil gebildet sind. In dieser Ausgestaltung können die Dichtung und die Haltevorrichtung gemeinsam in einem einzigen Fertigungsschritt ausgebildet werden. Die elastischen Elemente wie Haltevorrichtung und Dichtung sowie ggf. weitere Elemente können so mit dem Gehäuse des Klemmkastens im Spritzguss verbunden werden. Entsprechend lässt sich gegenüber einer separaten Ausbildung von Dichtung und Haltevorrichtung ein Fertigungsschritt einsparen.

In einer bevorzugten Ausgestaltung weist der Klemmenkasten einen ersten Gehäuseteil und einen von diesem lösbaren Deckel auf, wobei die Leiterplatte an dem Deckel befestigt ist. Zweckmäßigerweise ist dabei die Wandung mit dem Klemmelement zur lösbaren Klemmung der Leiterplatte in dem ersten Gehäuseteil angeordnet. Mit einem derart ausgebildeten Gehäuse lässt sich der Klemmenkasten besonders einfach montieren. So können das Einsetzen sowie die elektrische Kontaktierung der Leiterplatte einfach durch Aufsetzen des Deckels auf den ersten Gehäuseteil erfolgen. Der Deckel ist dazu zweckmäßigerweise in Richtung der Flachseiten der Leiterplatte auf den ersten Gehäuseteil aufsetzbar.

Ferner bevorzugt weist der Klemmenkasten einen ersten Gehäuseteil und einen von diesem lösbaren Deckel auf, wobei an dem Deckel zumindest ein elektrischer Kontakt gemeinsam mit zumindest einer Leiterbahn angeordnet ist. Vorzugsweise ist der elektrische Kontakt gemeinsam mit der zumindest einen Leiterbahn in den Deckel eingegossen. In dieser vorteilhaften Weiterbildung der Erfindung kann der Kontakt des Deckels mit der Leiterplatte elektrisch in Kontakt treten. Alternativ können über den Kontakt gegebenenfalls auch Leiterbahnsysteme des ersten Gehäuseteils und des Deckels miteinander verbunden oder auch weitere Komponenten an den Klemmenkasten angeschlossen werden. Durch das Eingießen des elektrischen Kontaktes gemeinsam mit der zumindest einen Leiterbahn kann der Deckel mit dem Kontakt und der Leiterbahn in einem einzigen Fertigungsschritt gefertigt werden. Daher kann auf ein Fixieren des elektrischen Kontaktes om Deckel und ein nachträgliches Kontaktieren des Kontaktes in weiteren Fertigungsschritten verzichtet werden.

Besonders bevorzugt weist der Klemmenkasten einen ersten Gehäuseteil und einen von diesem lösbaren Deckel auf, wobei an dem Deckel zumindest eine Kabeldurchführung und/oder ein elektrischer Steckkontakt angeordnet ist. Mit der Kabeldurchführung und/oder dem elektrischen Steckkontakt des Deckels ist der Klemmenkasten mit einem externen Gerät elektrisch verbindbar, beispielsweise mit einem Steuergerät. Im Falle eines Klemmenkastens zum elektrischen Anschluss an einen Elektromotor einer Umwälzpumpe handelt es sich bei dem externen Gerät besonders bevorzugt um eine Austauschpumpe oder um ein weiteres Pumpenaggregat. Bei dem Deckel des Klemmenkastens kann es sich insbesondere um einen optionalen Deckel von zwei Deckeln eines Klemmenkostensystems handeln, wie er nachfolgend beschrieben ist.

Der Klemmenkasten ist bevorzugt derart ausgestaltet, dass das Klemmelement für die Leiterplatte an einem ersten Gehäuseteil angeordnet ist, welcher zum Anschluss an den Elektromotor vorgesehen ist. Ein solcher motorseitiger Gehäuseteil des Klemmenkastens bildet ein Bodenteil des Gehäuses des Klemmenkastens. In einer solchen Ausgestaltung können vorteilhaft alle wesentlichen elektrischen Verbindungen im motorseitigen Gehäuseteil bzw. im Bodenteil gelegen sein, sodass das erforderliche Leiterbahnsystem lediglich auf den motorseitigen Gehäuseteil bzw, das Bodenteil des Gehäuses beschränkt bleiben kann.

Vorzugsweise weist bei dem Klemmkasten die Leiterplatte einen steuerbaren Schalter auf, welcher zumindest einen Steuerkontakt und zumindest einen Schaltkontakt aufweist. Dabei sind der Steuerkontakt mit einem elektrischen Steckkontaktbereich zum Anschluss des Elektromotors und der Schaltkontakt mit einem elektrischen Kontaktbereich des Klemmenkastens verbunden. Auf diese Weise kann ein elektrisches Signal an einen elektrischen Kontaktbereich des Klemmenkastens geleitet werden, welches beispielsweise anzeigt, ob der Elektromotor mit Strom versorgt wird. Beispielsweise kann über den elektrischen Kontaktbereich des Klemmenkastens ein Signal gegeben werden, wenn der Elektromotor keinen Strom erhält bzw. ausgefallen ist. Im Falle eines Klemmenkastens zum Anschluss an einen Elektromotor einer Umwälzpumpe kann insbesondere eine Austauschpumpe bzw. ein weiteres Pumpenaggregat an den elektrischen Kontaktbereich des Klemmenkastens angeschlossen sein, wobei das elektrische Signal die Austauschpumpe bzw. das weitere Pumpenaggregat zuschaltet oder betätigt. Dergestalt kann die Ausfallsicherheit eines Pumpenoggregates erhöht werden. Bei dem steuerbaren Schalter der Leiterplatte, z. B. ein Relais, kann es sich insbesondere um ein optionales Bauteil für eine Zusatzfunktion wie vorhergehend beschreiben handeln, welche an einer von zumindest zwei Leiterplatten eines Klemmenkastensystems vorgesehen ist, wie er nachfolgend beschrieben ist.

Bevorzugt weist der Klemmenkasten zumindest einen als Kunststoffgussteil ausgebildeten Gehäuseteil und einen Bedienschalter auf, wobei der Bedienschalter an dem Gehäuseteil angeordnet ist und zumindest ein feststehender elektrischer Schaltkontakt des Bedienschalters in den Gehäuseteil eingegossen ist. Auf diese Weise ist es möglich, einen Teil des Bedienschalters durch den Gehäuseteil des Klemmenkastens zu bilden. Damit ist es nicht erforderlich, den Schalter als separates Bauteil auf einer Leiterplatte zu montieren. Entsprechend kann auf eine aufwendige, beispielsweise mechanische, Verbindung von am Gehäuse des Klemmenkastens angeordneten Bedienelementen und dem Schalter auf einer Leiterplatte verzichtet werden. Ferner ist die Fertigung des Gehäuseteils besonders einfach. So ist durch das Eingießen des elektrischen Schaltkontakts in den Gehäuseteil ein weiterer Fertigungsschritt zum Fixieren des Schaltkontakts am Gehäuseteil entbehrlich. Vorzugsweise weist bei dem Klemmenkasten der Bedienschalter mehrere feststehende Schaltkontakte auf. So ausgestaltet kann der Bedienschalter mehr als zwei Schaltstellungen einnehmen.

Weiter bevorzugt weist der Bedienschalter einen beweglichen Teil auf, welcher einen beweglichen Schaltkontakt des Bedienschalters umfasst. Der bewegliche Kontakt des Bedienschalters kann dann in elektrisch leitende Verbindung mit dem feststehenden elektrischen Schaltkontakt treten. Besonders bevorzugt weist der bewegliche Teil des Bedienschalters zwei bewegliche Schaltkontakte auf, die miteinander leitend verbunden sind, und welche derart an dem beweglichen Teil des Bedienschalters angeordnet sind, dass zwei der feststehenden elektrischen Schaltkontakte mit den beiden beweglichen elektrischen Schaltkontakten in elektrisch leitende Verbindung treten können. Somit werden durch den beweglichen Teil des Bedienschalters zwei der feststehenden elektrischen Schaltkontakte des Gehäuseteils leitend miteinander verbunden. In dieser Ausgestaltung kann der Bedienschalter als Umschalter ausgebildet werden, indem je nach Stellung des beweglichen Teils des Bedienschalters unterschiedliche Paare von feststehenden elektrischen Schaltkontakten leitend miteinander verbunden sind.

Zweckmäßigerweise ist bei dem Klemmenkasten am Bedienschalter ein Federelement angeordnet, welches den beweglichen Teil des Bedienschalters in Richtung auf den Gehäuseteil kraftbeaufschlagt. Somit wird der bewegliche Teil des Bedienschalters am Gehäuse und damit nahe den feststehenden elektrischen Schaltkontakten gehalten, sodass die beweglichen Schaltkontakte des beweglichen Teils des Bedienschalters bei entsprechender Schaltstellung mit den feststehenden Schaltkontakten des Bedienschalters in leitende Verbindung treten.

Weiter bevorzugt ist der bewegliche Teil des Bedienschalters über eine Rastverbindung beweglich mit dem Gehäuseteil verbunden. Auf diese Weise kann der Klemmenkasten bei der Fertigung besonders einfach montiert werden, da der bewegliche Teil des Bedienschalters zur Montage lediglich in eine am Gehäuse vorgesehene Aufnahme eingesetzt werden muss. Ober die rastende Verbindung wird der Bedienschalter danach in dieser Position drehbeweglich gehalten. In bevorzugter Ausgestaltung ist bei dem Klemmenkasten der Bedienschalter ein Drehschalter. Insbesondere ist der bewegliche Teil des Drehschalters ein zylindrischer Drehkörper.

Vorzugsweise sind an einer gehäuseseitigen Stirnwand des Drehschalters diametral um die zentrale Dreh- bzw. Längsachse des Drehkörpers zwei gemeinsam mit dem Drehkörper drehbewegliche Schaltkontakte angeordnet, die mit feststehenden, am Gehäuseteil angeordneten elektrischen Schaltkontakten leitend in Kontakt treten können. Dazu sind die feststehenden elektrischen Schaltkontakte vorzugsweise derart um die Drehachse des Drehkörpers herum am Gehäuseteil verteilt, dass sich ein erster feststehender Schaltkontakt umfänglich um etwa den halben Umfang um die Drehachse erstreckt. Die übrigen Schaltkontakte sind dabei mit gleichem Abstand voneinander und mit gleichem Abstand von der Drehachse um den verbleibenden Umfang um die Drehachse verteilt. Diese übrigen Schaltkontakte erstrecken sich dabei um deutlich kleinere Teile des Umfangs als der der erste Schaltkontakt. Somit schleift der erste bewegliche Schaltkontakte bei Drehung des Drehkörpers auf dem ersten feststehenden elektrischen Schaltkontakt. während der zweite bewegliche Schaltkontakt mit jedem der übrigen feststehenden Schaltkontakte durch Drehung des Drehkörpers leitend verbindbar ist. Ferner bevorzugt ist bei dem Klemmenkasten der Bedienschalter ein Drehzahlwahlschalter des mit dem Klemmenkasten verbundenen Elektromotors.

In einer bevorzugten Ausgestaltung ist der Klemmenkasten derart ausgestaltet, dass der Bedienschalter ein Anzeigeelement aufweist. Beispielsweise ist das Anzeigelement zur Anzeige des Betriebszustandes des Elektromotors vorgesehen.

Besonders bevorzugt ist das Anzeigeelement eine Leuchtanzeige. Vorteilhafterweise weist in dieser Ausgestaltung der Klemmenkasten ein Leuchtmittel und einen Lichtleiter auf. Dabei sind Leuchtmittel und Leuchtanzeige mittels des Lichtleiters lichtleitend miteinander verbunden. Auf diese Weise kann das Leuchtmittel zur Ausleuchtung der Leuchtanzeige von der Leuchtanzeige beabstandet sein. Idealerweise ist das Leuchtmittel eine Leuchtdiode, welche auf einer Leiterplatte, insbesondere der oben beschriebenen Leiterplatte, angeordnet ist. So kann die Leiterplatte mit dem Leuchtmittel im inneren des Klemmkastens weiter beabstandet von dessen Gehäusewandung angeordnet werden.

Vorzugsweise bildet dabei ein Teil des Bedienschalters, insbesondere die Welle eines Drehschalters, zumindest einen Teil des Lichtleiters. Bildet die Welle eines Drehschalters zumindest einen Teil des Leichtleiters, so verschiebt sich der Lichtpfad durch den Lichtleiter auch bei einer Änderung der Drehstellung des Drehschalters nicht. Entsprechend bleibt die Ausleuchtung der Leuchtanzeige von einer Betätigung des Drehschalters unbeeinflusst. Bevorzugt ist der Lichtleiter oder eines seiner Teile als transparentes lichtleitendes Kunststoffelement ausgebildet. Alternativ kann der Lichtleiter als einfache axiale Öffnung, d. h. eine axiale Durchführung, ausgebildet sein. So kann die Welle rohrförmig sein.

Ferner bevorzugt sind bei dem Klemmenkasten einzelne Leiterbahnen des Leiterbahnsystems vor dem Eingießen in den Gehäuseteil isolierend miteinander verbunden. Auf diese Weise lassen sich die Leiterbahnen bei der Herstellung des Klemmenkastens äußerst einfach in den Gehäuseteil eingießen. So können die Leiterbahnen durch die isolierende Verbindung, insbesondere dann, wenn sie als starre Verbindung ausgeführt ist, als einstückiges bzw. einteilig handhabbares Modul in den Gehäuseteil eingegossen werden. Insbesondere müssen die Leiterbahnen bei der Herstellung des Klemmenkastens vor dem Gießen des Gehäuseteils nicht einzeln in dem Werkzeug ausgerichtet bzw. positioniert werden. Vielmehr muss lediglich das einstückig bzw. einteilig handhabbare Modul in das Werkzeug eingelegt bzw. ausgerichtet werden.

Das erfindungsgemäße Klemmenkastensystem weist einen solchen eingangs beschriebenen Klemmenkasten auf. Dabei umfasst das Klemmenkastensystem zumindest zwei unterschiedliche Leiterplatten, welche wahlweise in das zumindest eine Klemmelement des Klemmenkastens einsetzbar sind. Mit einem solchen modularen Klemmenkastensystem kann der Klemmenkasten unterschiedliche Steuer- und/oder Kontrollfunktionen aufweisen, welche durch die jeweilige im Klemmenkasten geklemmte Leiterplatte bestimmt werden. In einer solchen Ausgestaltung kann daher der Funktionsumfang des Klemmenkastens geändert werden, indem lediglich eine Leiterplatte des Klemmenkastens ausgetauscht wird. Beispielsweise kann eine der zumindest zwei Leiterplatten einen steuerbaren Schalter aufweisen, wie er oben beschrieben ist.

Ein erfindungsgemäßes Klemmenkastensystem umfasst alternativ oder in Gestalt des zuvor beschriebenen Klemmenkastensystems neben dem Klemmenkasten gemäß der vorhergehenden Beschreibung zwei unterschiedliche mit einem Gehäuseteil des Klemmenkastens wahlweise verbindbare Deckel. Diese Deckel können den Funktionsumfang des Klemmenkastens ändern, beispielsweise kann der Klemmenkasten je nach eingesetztem Deckel unterschiedliche oder eine unterschiedliche Anzahl von elektrischen Anschlusskontakten und/oder Kabeldurchführungen aufweisen, mit denen weitere Geräte angeschlossen werden können. Bevorzugt weist einer der beiden Deckel als optionaler Deckel einen elektrischen Anschlusskontakt auf, der mit einem steuerbaren Schalter an einer Leiterplatte im Inneren des Klemmenkastens verbindbar ist, wie er oben beschrieben wurde. Alternativ kann der optionale Deckel eine Durchführung für ein mit dem steuerbaren Schalter verbundenes Kabel aufweisen. Idealerweise umfasst das Klemmenkastensystem dabei zwei Leiterplatten, von denen eine Leiterplatte als optionale Leiterplatte den steuerbaren Schalter aufweist und in dem optionalen Deckel befestigt ist. In dieser Ausgestaltung kann ein externes Gerät über den optionalen Deckel an den Klemmenkasten angeschlossen und über den steuerbaren Schalter der optionalen Leiterplatte in Abhängigkeit vom Betriebszustand des Elektromotors ein Signal des steuerbaren Schalters empfangen. Dazu ist lediglich der optionale Deckel des Klemmenkastensystems mit der optionalen Leiterplatte in den Klemmenkasten einzusetzen. Die Leiterplatte wird wie oben beschrieben durch ein Klemmelement kontaktiert.

Das erfindungsgemäße Pumpenaggregat ist vorzugsweise ein Umwälzpumpenaggregat. Dieses Pumpenaggregat weist gemäß der Erfindung einen Klemmenkasten oder ein Klemmenkastensystem wie vorhergehend beschrieben auf.

Die Erfindung wird nachfolgend anhand eines in der Zeichnung dargestellten Ausführungsbeispiels näher erläutert. Es zeigen:
- Fig. 1: schematisch ein erfindungsgemäßes Heizungsumwälzpumpenaggregat mit einem erfindungsgemäßen Klemmenkasten,
- Fig. 2: den erfindungsgemäßen Klemmenkasten gemäß Fig. 1 in einer perspektivischen Darstellung,
- Fig. 3A: ein Bodenteil des Gehäuses des Klemmenkastens gemäß Fig. 1 in einer perspektivischen Darstellung,
- Fig. 3B: einen Drehzahlwahlschalter des Bodenteils des Gehäuses gemäß Fig. 3A in einer Vergrößerung,

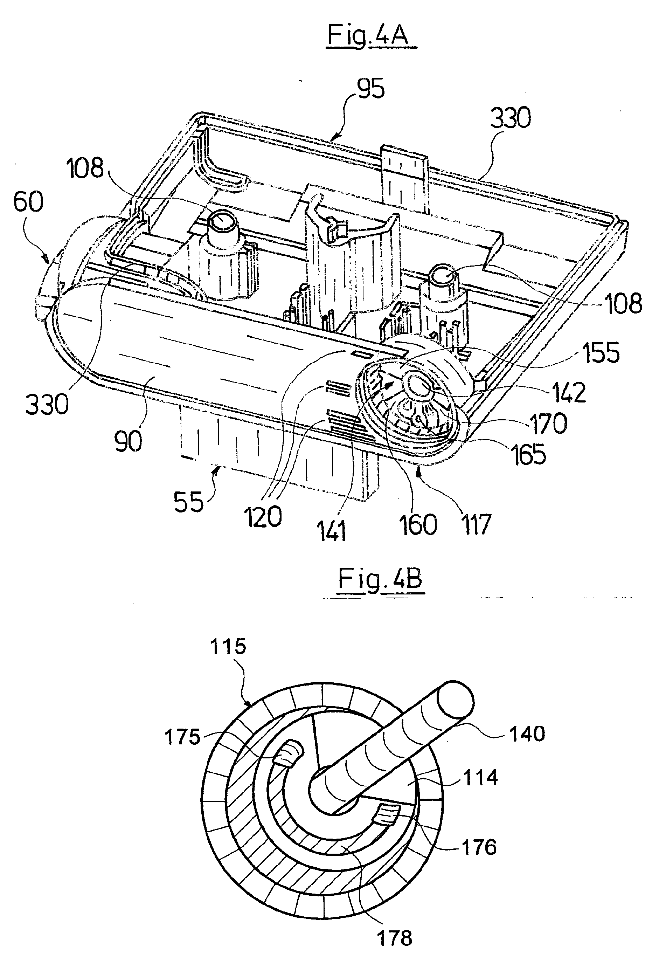

- Fig. 4A: das Bodenteil gemäß Fig. 3A in einer perspektivischen Darstellung,
- Fig. 4B: schemaflsch den beweglichen Teil des Drehzahlwahlschalters gemäß Fig. 3B,
- Fig. 5A: ein Leiterbahnsystem des Bodenteils gemäß Fig. 4A mit einem Schaltkontakt des Bedienschalters vor dem Vorvergießen,
- Fig. 5B: das Leiterbahnsystem gemäß Fig. 5A nach dem Vorvergießen,
- Fig. 6A: das Bodenteil des Gehäuses des Klemmenkastens gemäß Fig. 3A in einer perspektivischen Darstellung,
- Fig. 6B: ein Klemmelement des Bodenteils gemäß Fig. 3A zur Klemmung einer Leiterplatte mit einer Leiterplatte in einer Vergrößerung im Schnitt,
- Fig. 7: das Bodenteil gemäß Fig. 3A mit einem zweiten Deckel eines erfindungsgemäßen Klemmenkastensystems in einer perspektivischen Darstellung und
- Fig. 8: den zweiten Deckel gemäß Fig. 7 in einer perspektivischen Darstellung.

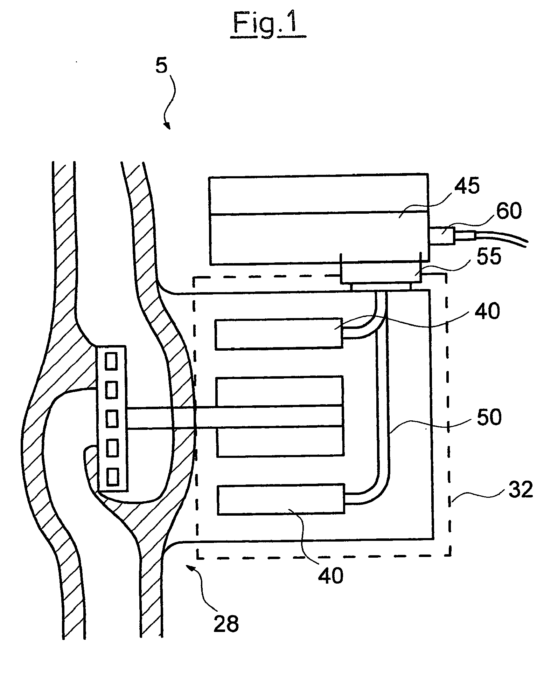

Bei dem in Fig. 1 dargestellten erfindungsgemäßen Pumpenaggregat handelt es sich um ein Heizungsumwälzpumpenaggregat 5 mit einem Elektromotor 32. Darüber hinaus weist der Elektromotor 32 einen Stator 40 auf, welcher von einem erfindungsgemäßen Klemmenkasten 45 mit elektrischer Energie gespeist wird. Zusätzlich übernimmt die Elektronik des Klemmenkastens 45 die Steuerung und Überwachung des Elektromotors 32. Dazu ist der Stator 40 des Elektromotors 32 über elektrische Leitungen 50 mit einem elektrischen Steckkontaktbereich 55 des Klemmekastens 45 verbunden. Der Klemmenkasten 45 ist zur Versorgung mit elektrischer Energie über einen elektrischen Steckkontaktbereich 60 an eine Spannungsquelle (in der Zeichnung nicht dargestellt) angeschlossen.

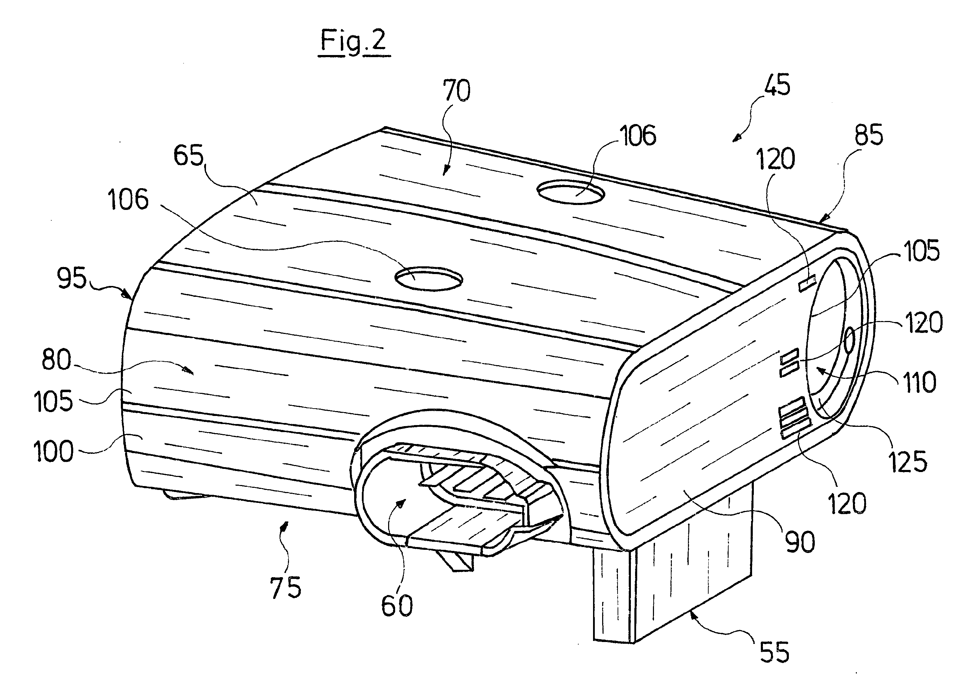

Der Klemmenkasten 45 weist wie in Fig. 2 gezeigt ein Gehäuse 65 auf, welches im Wesentlichen die Gestalt eines flachen Quaders besitzt. Die Flachseite 70 bildet dabei die vom Elektromotor 32 abgewandte Deckel- bzw. Oberseite des Gehäuses 65 und die Flachseite 75 die motorseitige, d.h. die dem Elektromotor 32 zugewandte Boden- bzw. Unterseite des Gehäuses 65. Die beiden kürzeren Schmalseiten 80, 85 des Gehäuses 65 sind nach außen gerundet und weisen die Gestalt eines entlang seiner Längsmittelebene geteilten Kreiszylindermantels auf. Die beiden längeren Schmalseiten des Gehäuses 65 sind plan ausgestaltet und bilden die Vorderseite 90 und die Rückseite 95 des Klemmenkastens 45.

Das Gehäuse 65 setzt sich aus einem motorseitigen Gehäuseteil in Form eines Bodenteils 100 und einem Deckel 105 zusammen, welche durch Schrauben (in der Zeichnung nicht dargestellt) lösbar miteinander verbunden sind. Der Deckel 105 weist an seiner Oberseite 70 zwei Durchführungen 106 auf, durch welche die Schrauben in Löcher 108 an der Unterseite 75 des Bodenteils 100 geschraubt werden können. Das Gehäuse 65 lässt sich dabei enflang der zur Ober- und Unterseite 70, 75 parallelen Längsmittelebene in Bodenteil 100 und Deckel 105 trennen. Die Vorderseite 90 ist dabei fest mit dem Bodenteil 100 verbunden. Der elektrische Steckkontaktbereich 55 zum Anschluss an den Elektromotor 32 ragt an der Unterseite 75 des Bodenteils 100 senkrecht nach außen. An einer kürzeren Schmalseite 80 des Bodenteils 100 ragt der elektrische Steckkontaktbereich 60 zum Anschluss an eine Spannungsquelle seitlich senkrecht nach außen.

Zur Auswahl der Drehzahl des Elektromotors 32 ist an der Vorderseite 90 des Klemmenkastens 45 ein Drehzahlwahlschalter in Form eines Drehschalters 110 angeordnet. Der Drehschalter 110 umfasst einen kreiszylindrisch ausgebildeten, mit einer Stimfläche 114 zum Gehäuse 65 gewandten und drehbeweglich im Gehäuse 65 angeordneten Drehkörper 115. Der Drehkörper 115 ist dabei nahe einer kürzeren Schmalseite 85 des Gehäuses 65 angeordnet, sodass die kreisrunde Mantelfläche 116 des Drehkörpers 115 und die nach außen gekrümmte Schmalseite 85 des Gehäuses 65 konzentrisch zueinander gelegen sind. Auf diese Weise ist der Klemmenkasten 45 platzsparend ausgebildet. Der Drehkörper 115 befindet sich dazu in einer Aufnahme 117 in Gestalt einer kreiszylindrischen Ausnehmung an der Vorderseite 90 des Bodenteils 100.

Nahe dem Drehkörper 115 sind an der Vorderseite 90 des Gehäuses 65 Markierungen 120 aufgebracht, an welchen eine korrespondierende Markierung 125 des Drehkörpers 115 je nach Drehstellung des Drehkörpers 115 zur Anlage kommen kann. Mittels dieser Markierungen 120, 125 kann eine geeignete Drehstellung des Drehkörpers 115 zur Wahl der Drehzahl des Elektromotors 32 durch einen Benutzer abgelesen werden.

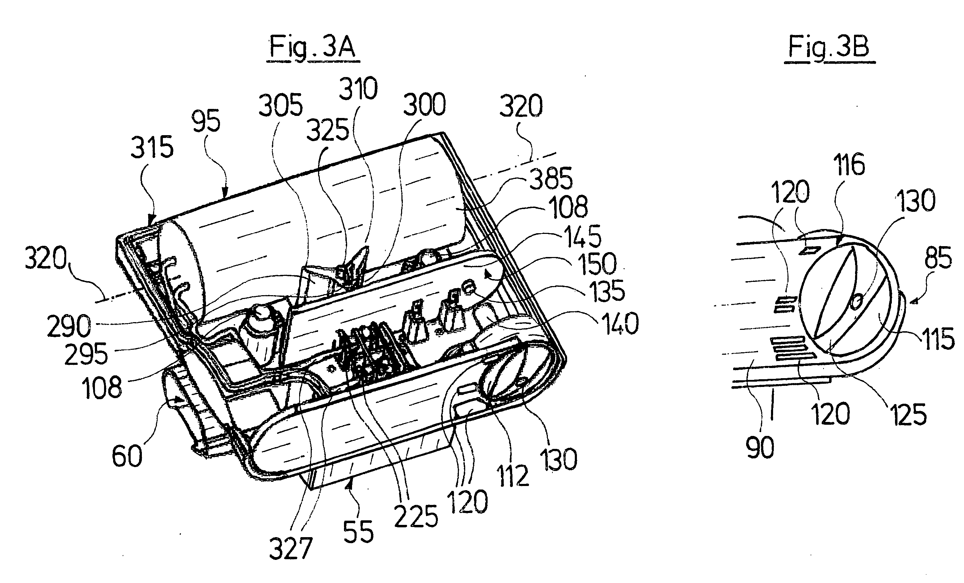

Der nähere Aufbau des Bodenteils 100 kann Fig. 3A entnommen werden. Im Zentrum des Drehkörpers 115 des Drehschalters 110 ist eine Leuchtanzeige 130 als Motorbetriebsanzeige ausgebildet, d.h. die Leuchtanzeige 130 leuchtet, wenn der Elektromotor 32 betrieben wird. Die Leuchtanzeige 130 wird dazu von einer Leuchtdiode 135 ausgeleuchtet. Dazu wird das von der Leuchtdiode 135 abgestrahlte Licht durch eine als Hohlschaft ausgebildete Welle 140 des Drehkörpers 115 geleitet, welche im Zentrum des Drehkörpers 115 angeordnet ist und sich mit ihrer Längsachse senkrecht zur Vorderseite 90 in das Innere des Gehäuses 65 fortstreckt. Somit wirkt der Hohlraum in der Welle 140 als Lichtleiter für das von der Leuchtdiode 135 abgestrahlte Licht. Im Inneren des Gehäuses 65 ist die Welle 140 an einer Stirnseite 141 der Aufnahme 117 in einer Durchführung 142 drehbar gehalten, sodass der Drehkörper in der Aufnahme 117 drehbar ist. Die Welle 140 endet dabei im Inneren des Gehäuses 65 nah der Leuchtdiode 135. An der nach außen gewandten Stirnseite des Drehkörpers 115 schließt die Welle 140 mit der Leuchtanzeige 130 bündig ab. Auf diese Weise ist die Leuchtdiode 135 mit der Leuchtanzeige 130 auf geradem Wege lichtleitend verbunden, sodass die Leuchtanzeige 130 von der Leuchtdiode 135 ausgeleuchtet wird. Alternativ zum dargestellten Ausführungsbeispiel kann in der Welle 140 das Licht auch durch einen festen transparenten Lichtleiter, beispielsweise aus Kunststoff, geleitet werden, der in dem Hohlschaft eingebettet ist oder selber die Welle bildet.

Das Licht wird von einer das Stimende des Hohlschaftes überdeckenden Streuscheibe der Leuchtanzeige 130 nach außen ausgestreut, wodurch die Leuchtanzeige 130 als leuchtend wahrnehmbar ist. Die Leuchtdiode 135 ist nahe der gehäuseeinwärts weisenden Öffnung der Welle 140 an einer Leiterplatte 145 angeordnet. Dabei befindet sich die Leuchtdiode 135 an der der Vorderseite 90 des Klemmenkastens 45 zugewandten Seite 150 der beiden Flachseiten 150, 152 der Leiterplatte 145. Die Leiterplatte 145 ist mit ihren Flachseiten 150, 152 senkrecht zur Unterseite 75 und parallel zur Vorderseite 90 in das Gehäuse 65 des Klemmenkastens 45 geklemmt (näheres zur Anordnung der Leiterplatte 145 ist weiter unten ausgeführt).

Neben dem beweglichen Drehkörper 115 weist der Drehschalter 110 feststehende elektrische Schaltkontakte 155, 160, 165, 170 auf. Die feststehenden elektrischen Schaltkontakte 155, 160, 165, 170 sind dabei an der Stirnseite 141 umfänglich um die Durchführung 142 für die Welle 140 herumgruppiert. Der feststehende Schaltkontakt 155 überdeckt dabei einen großen Winkelbereich um die Durchführung 142, welcher nahezu 180° ausmacht. Die Schaltkontakte 160, 165, 170 hingegen erstrecken sich lediglich über sehr schmale Winkelbereiche um die Durchführung 142 und sind voneinander gleich beabstandet und mit gleichem Abstand zur Durchführung 142 über den verbleibenden Umfang um die Durchführung 142 verteilt. Ober den Drehschalter 110 kann nun eine von drei Drehzahlstufen des Elektromotors 32 gewählt werden, indem einer der schmalwinkligen feststehenden Kontakte 160, 165, 170 elektrisch leitend mit dem breitwinkligen feststehenden elektrischen Schaltkontakt 155 verbunden wird. Dazu weist der Drehkörper 115 an seiner Stirnfläche 114 zwei fest mit dem Drehkörper verbundene drehbewegliche Schaltkontakte 175, 176 auf. Die Schaltkontakte 175, 176 nehmen jeweils einen ebenso kleinen Winkelbereich um die Welle 140 ein wie die schmalwinkligen feststehenden elektrischen Schaltkontakte 160, 165, 170 und sind von der Welle 140 ähnlich welt beabstandet wie die feststehenden elektrischen Schaltkontakte 160, 165, 170 von der Durchführung 142. Die beiden Schaltkontakte 175, 176 sind dabei diametral entgegengesetzt um die Welle 140 angeordnet und über eine Leiterbahn 178 miteinander verbunden, die auf der Stirnfläche 114 des Drehkörpers 115 die Welle 140 umläuft und einen 180°-winkel überstreicht. In dieser Ausbildung kann nun einer 176 der beiden mit dem Drehkörper 115 drehbeweglichen Schaltkontakte 175, 176 mit einem der schmalwinkligen, feststehenden elektrischen Schaltkontakte 160, 165, 170 in Kontakt treten. Der zweite bewegliche elektrische Schaltkontakt 175 schleift dabei über den breitwinkligen feststehenden elektrischen Schaltkontakt 155. Je noch Drehstellung des Drehkörpers 115 wird daher eine von drei elektrischen Schaltkonfigurationen gewählt.

Darüber hinaus ist an der Welle 140 eine Druckfeder (in der Zeichnung nicht dargestellt) angeordnet, die die Welle 140 in Richtung in das Gehäuseinnere kraftbeaufschlagt. Auf diese Weise können die drehbeweglichen Kontakte 175, 176 stets mit den feststehenden elektrischen Kontakten 155, 160, 165, 170 in elektrischen Kontakt gehalten werden.

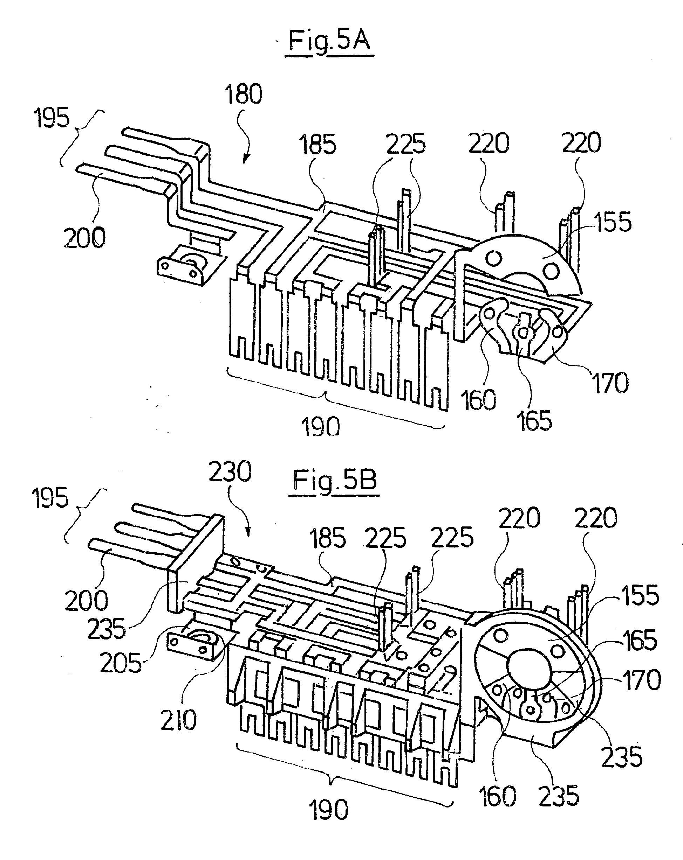

Die feststehenden elektrischen Schaltkontakte 155, 160, 165, 170 des Drehschalters 110 sind in das Bodenteil 100 des Gehäuses 65 eingegossen. Die Schaltkontakte 155, 160, 165, 170 sind dabei Teil eines in Fig. 5A dargestellten Leiterbahnsystems 180. Dieses Leiterbahnsystem 180 besteht im Wesentlichen aus einem dünn und flächig ausgebildeten System von Leiterbahnen 185. Die feststehenden elektrischen Schaltkontakte 155, 160, 165, 170 des Drehschalters 110 stellen dabei die Endbereiche einzelner Leiterbahnen 185 dar. Die Schaltkontakte 155, 160, 165, 170 sind von den Leiterbahnen 185 um 90° derart abgewinkelt, dass sie in einer gemeinsamen Ebene liegen und gemeinsam einen Teil der Stirnseite 141 der Aufnahme 117 bilden. Das Leiterbahnsystem 180 weist weitere feststehende elektrische Kontakte auf, die als Endbereiche einzelner Leiterbahnen 185 ausgestaltet sind. So bildet eine Gruppe 190 von elektrischen Kontakten den elektrischen Teil des elektrischen Steckkontaktbereiches 55 zum Anschluss des Klemmenkastens 45 an den Elektromotor 32. Eine weitere Gruppe 195 von elektrischen Kontakten bildet den elektrischen Teil des elektrischen Steckkontaktbereiches 60 zum Anschluss des Klemmenkastens 45 an eine Spannungsquelle.

Ein elektrischer Steckkontakt der Gruppe von elektrischen Steckkontakten 195 bildet dabei ein Erdungselement 200 zur Erdung des angeschlossenen Elektromotors 32, Dazu ist das Erdungselement 200 über das Leiterbahnsystem 180 mit einer außerhalb des motorseitigen Bodenteils 100 des Gehäuses 65 des Klemmenkastens 45 gelegenen Kontaktfläche 205 verbunden. Im montierten Zustand des Klemmenkastens 45 kommt die Kontaktfläche 205 mit dem Gehäuse des Elektromotors 32 durch direkte Anlage in elektrischen Kontakt. Zur Unterstützung des elektrischen Kontakts ist die Kontaktfläche 205 mit einer Durchführung 210 versehen, durch die eine Schraube (in der Zeichnung nicht dargestellt) zur Befestigung des Klemmenkastens 45 an den Elektromotor 32 geführt wird. Die Schraube drückt dabei die Kontaktfläche 205 nach der Montage des Klemmenkastens 45 an den Elektromotor 32 gegen das Gehäuse des Elektromotors 32.

Die zuvor genannten elektrischen Kontakte 155, 160, 165, 170 bzw. Gruppen von elektrischen Kontakten 190, 195 sind jeweils an den äußeren Bereichen des dünn und flächig ausgestalteten Leiterbahnsystems 180 angeordnet. Das Leiterbahnsystem 180 ist in eine Wandung bzw. Bodenfläche 215 des Bodenteils 100 des Gehäuses 65 des Klemmenkastens 45 eingegossen. Die Gruppe 190 der von den einzelnen Leiterbahnen 185 abgewinkelten elektrischen Kontakte ragt dabei aus dem motorseitigen Bodenteil 100 des Gehäuses 65 des Klemmenkastens 45 nach unten, also aus der Unterseite 75 des Gehäuses 65 des Klemmenkastens 45 heraus. Die Gruppe 195 elektrischer Kontakte ragt seitlich aus der dem Drehschalter 110 fernen Schmalseite 80 des Bodenteils 100 des Gehäuses 65 heraus. Die elektrischen Kontakte 155, 160, 165, 170 hingegen bilden die Stirnseite 141 der Aufnahme 117 und liegen somit in der Oberfläche des Bodenteils 100 des Gehäuses 65 des Klemmenkastens 45. Daneben weist das Leiterbahnsystem 180 Paare 220, 225 von federnden Klemmzungen auf, welche sich senkrecht zu den Leiterbahnen 185 orientiert nach oben, d.h. senkrecht zur Bodenfläche 215 des Bodenteils 100 des Gehäuses 65 orientiert und in das innere des Klemmenkastens 45 gerichtet, vom Leiterbahnsystem 180 fortstrecken. Auch die Paare 220, 225 federnder Klemmzungen stellen dabei elektrische Kontakte dar, die jedoch im Gegensatz zu den oben erwähnten Kontakten im Innenbereich des Klemmenkastens 45 gelegen sind. Näheres hierzu wird weiter nachfolgend ausgeführt.

Wie in Fig. 5B gezeigt, ist das Leiterbahnsystem 180 nicht unmittelbar in die Bodenfläche 215 eingegossen. Vielmehr sind die einzelnen Leiterbahnen 185 zunächst miteinander zu einem einstückig bzw. einteilig handhabbaren Modul 230 vorvergossen. Dazu sind die Leiterbahnen 185 teilweise mit Kunststoff 235 umspritzt. Auf diese Weise kann das Modul 230 deutlich einfacher in die Bodenfläche 215 eingegossen werden, als dies mit einer Ansammlung einzelner Leiterbahnen 185, die dazu einzeln in einem Werkzeug zu positionieren wären, möglich wäre.

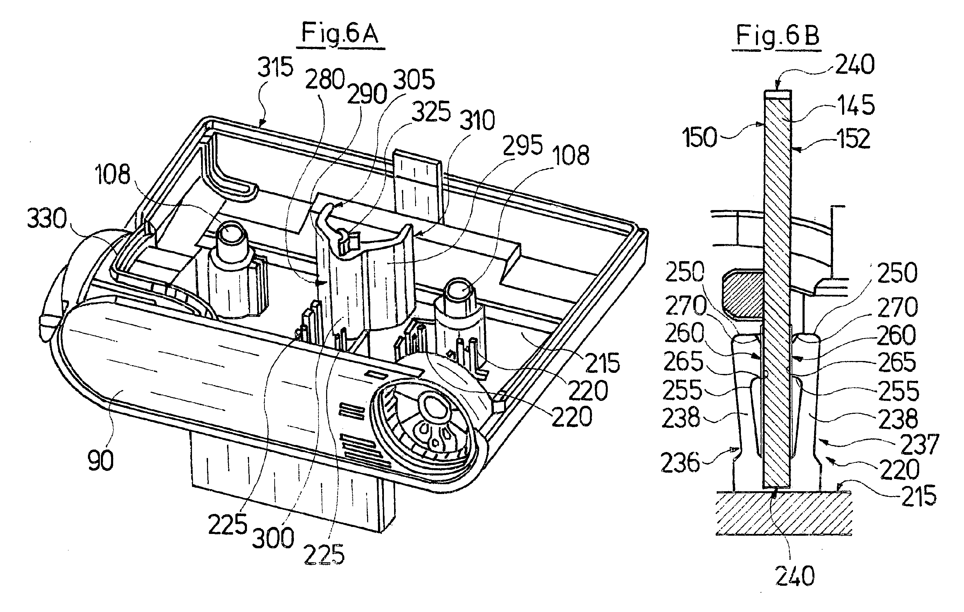

Die Ausgestaltung der Paare 220, 225 von federnden Klemmzungen kann Fig. 6A und Fig. 6B entnommen werden. In Fig. 6A ist das Bodenteil 100 des Gehäuses 65 des Klemmenkastens 45 ohne eingesetzte Leiterplatte 145 gezeigt. Die Paare federnder Klemmzungen 220, 225 erstrecken sich in das Innere des Gehäuses 65 des Klemmenkastens 45 und senkrecht zur Bodenfläche 215 von dieser weg. Die Paare 220 federnder Klemmzungen dienen dabei zur Klemmung der Leiterplatte 145 und weisen jeweils zwei einander gegenüberliegende Klemmzungen 236, 237 auf. Zwei Paare 220 von Klemmzungen sind entlang einer Ebene positioniert, die parallel zur Vorderseite 90 des Klemmenkastens 45 verläuft. Auf diese Weise lässt sich die Leiterplatte 145 senkrecht zur Bodenfläche 215 und parallel zur Vorderseite 90 des Klemmenkastens 45 klemmen.

Die Klemmung der Leiterplatte 145 durch die Klemmzungenpaare 220 ist in Fig. 6B in einer Schnittansicht gezeigt. Die Leiterplatte 145 befindet dabei in ihrer Klemmposition, in welcher sie mit ihren Flachseiten 150, 152 senkrecht zur Bodenfläche 215 orientiert ist. Dabei ist sie mit der Richtung ihrer längsten Ausdehnung parallel zur Vorderseite 90 und zur Bodenfläche 215 des Gehäuses 65 des Klemmenkastens orientiert. In der in Fig. 6B dargestellten Schnittansicht ist die Vorderseite 90 des Klemmenkastens 45 dabei links von der Leiterplatte 145 gelegen. Die Schmalseiten 240 der Leiterplatte sind parallel zur Bodenfläche 215 des Klemmenkastens 45 orientiert. Die Leiterplatte 145 ist an den beiden Flachseiten 150, 152 durch Paare 220 von Klemmzungen geklemmt, von denen ein Paar 220 in der Schnittansicht dargestellt ist. Die einander gegenüberliegenden Klemmzungen 236, 237 des Klemmzungenpaares 220 sind bei eingesetzter Leiterplatte 145 beiderseits an den einander abgewandten Flachseiten 150, 152 der Leiterplatte 145 gelegen. Sie sind als sich im Wesentlichen senkrecht von der Bodenfläche 215 forterstreckende federnde Laschen 238 ausgebildet und weisen an ihren der Bodenfläche 215 fernen Enden 250 jeweils einen zu den Flachseiten 150, 152 der Leiterplatte 145 weisenden Vorsprung 255 auf, dessen der Leiterplatte 145 zugewandten Seite eine elektrische Kontaktfläche 260 bildet. Die Kontaktflächen 260 geraten bei Klemmung der Leiterplatte 145 mit korrespondierenden Kontaktflächen 265 der Leiterplatte 145 flächig in elektrischen Kontakt. Die elektrische Kontaktflächen 265 sind als Teil der auf der Leiterplatte 145 befindlichen Leiterbahnen ausgebildet und befindet sich nahe der unteren Schmalseite 240 und an den Flachseiten 150, 152 der Leiterplatte 145.

Die Kontaktflächen 260 der Klemmzungen 236, 237 sind gegen die Kontaktflächen 265 der Leiterplatte 145 kraftbeaufschlagt, womit gleichzeitig ein sicherer Halt und eine zuverlässige elektrische Kontaktierung der Leiterplatte 145 gewährleistet ist. Die Kraftbeaufschlagung der Kontaktflächen 260 in Richtung auf die Leiterplatte 145 ist dabei durch die Rückstellkraft der federnden Laschen 238 der Klemmzungen 236,237 bedingt, welche beim Einsetzen der Leiterplatte 145 senkrecht von den Flachseiten 150,152 der Leiterplatte 145 weg aus ihrer Ruhelage ausgelenkt werden.

Das Einsetzen der Leiterplatte 145 zwischen die Klemmzungen 236, 237 wird derart durchgeführt, dass die Leiterplatte 145 senkrecht auf die Bodenfläche 215 zu bewegt wird. Bevor die Leiterplatte 145 mit den Klemmzungen 236, 237 in Berührung kommt, befinden sich die Klemmzungen 236, 237 in ihrer Ruhelage. In der Ruhelage ist der Abstand der einander zugewandten elektrischen Kontaktflächen 260 der Klemmzungen 236, 237 voneinander geringer als die Dicke der Leiterplatte 145, also die Ausdehnung der Leiterplatte 145 senkrecht zu ihren Flachseiten 150, 152. Wenn die untere Schmalseite 240 der Leiterplatte 145 die von der Bodenfläche 215 entfernten Enden 250 der Klemmzungen 236, 237 erreicht, werden bei der weiteren Bewegung der Leiterplatte 145 auf die Bodenfläche 215 zu infolge konvexer Rundungen 270 der Vorsprünge 255 die Kontaktflächen 260 des Klemmzungenpaares 220 auseinander gedrückt. Dabei werden die Klemmzungen 236, 237 an ihren von der Bodenfläche 215 entfernten Enden 250 senkrecht zu den Kontaktflächen 260 bzw. senkrecht zu den Flachseiten 150, 152 der Leiterplatte 145 ausgelenkt. Die federnden Laschen 238 der Klemmzungen 236, 237 werden dabei an ihren von der Bodenfläche 215 fernen Abschnitten auseinander gebogen. Aus dieser Biegung der Laschen 238 resultiert eine Rückstellkraft der Laschen 238 zurück in ihre Ruhelage. Daher werden die Kontaktflächen 260 über die Laschen 238 der Klemmzungen 236, 237 in Richtung auf die Leiterplatte 145 kraftbeaufschlagt. Die Leiterplatte 145 gelangt somit mit ihren Flachseiten 150, 152 mit den Kontaktflächen 260 des Klemmzungenpaares 220 in Kontakt. Die Kontaktflächen 260 des Klemmzungenpaares 220 schleifen bei der weiteren Bewegung der Leiterplatte 145 auf die Bodenfläche 215 zu über die Flachseiten 150, 152 der Leiterplatte 145, bis sie mit den Kontaktflächen 265 der Leiterplatte 145 in Kontakt treten. Die Kontaktflächen 265 der Leiterplatte 145 liegen bündig in zumindest einer Flachseite 150, 152 der Leiterplatte 145. Alternativ zu dieser gezeigten Ausführungsform können die Kontaktflächen 265 der Leiterplatte 145 auch als Vertiefungen in zumindest einer der Flachseiten 150, 152 ausgebildet sein, sodass das Paar von Klemmzungen 220 und die Leiterplatte 145 über eine Rastverbindung lösbar und gleichzeitig fest miteinander verbunden sind.

Das Bodenteil 100 weist darüber hinaus eine Haltevorrichtung in Form eines Klemmhalters 280 zur Klemmung eines Kondensators 285 auf. In Fig. 6A ist das Bodenteil 100 ohne den eingelegten Kondensator 285 dargestellt, in Fig. 3A ist der Kondensator 285 mit dem Klemmhalter 280 geklemmt. Der Klemmhalter 280 ist dazu als ein Paar von zwei Klemmschenkeln 290, 295 ausgebildet, die jeweils als Wandung senkrecht zur Bodenfläche 215 orientiert nach oben von der Bodenfläche 215 wegstehen. Die beiden Klemmschenkel 290, 295 treffen sich in einer zur Vorderseite 90 des Klemmkastens 45 gewandten gemeinsamen Scheitelkante 300. Die von der Vorderseite 90 abgewandten Kanten der Klemmschenkel 290, 295 bilden dabei zwei senkrecht zur Bodenfläche 215 orientierte Klemmflächen 305, 310, die den Kondensator 285 gegen die Rückwand 315 des Bodenteils 100 klemmen, sodass die Längsachse 320 des Kondensators 285 parallel zur Rückseite 315 des Bodenteils 100 orientiert ist.

Die beiden Wandungen 290, 295 bestehen dabei aus einem elastischen Kunststoff. Zur Klemmung des Kondensators 285 ist der Abstand zwischen den Klemmflächen 305, 310 des Klemmhalters 280 und der Rückseite 315 des Bodenteils 100 etwas geringer als der Durchmesser des Kondensators 285 gewählt. So werden die Klemmflächen 305, 310 vom Kondensator 285 elastisch ausgelenkt. Aufgrund seiner Elastizität übt der Kunststoff der Klemmflächen 305, 310 auf den Kondensator 285 eine Rückstellkraft aus, welche den Kondensator 285 in seiner Klemmposition in Richtung auf die Rückseite 315 des Bodenteils 100 kraftbeaufschlagt.

Die beiden Wandungen 290, 295 umschließen an ihrer gemeinsamen Scheitelkante 300 eine Befestigungsstange 325, welche sich mit sternförmigen Profil senkrecht von der Bodenfläche 215 fortstreckt. Auf diese Weise sind die beiden Wandungen 290, 295 drehfest an der Bodenflache 215 und somit drehfest an dem Bodenteil 100 des Gehäuses 65 befestigt.

Der Kondensator 285 ist über elektrische Leitungskabel 327 mit der Leiterplatte 145 verbunden. Die Leitungskabel 327 sind am Bodenteil 100 des Gehäuses 65 des Klemmenkastens 45 über die Paare 225 von Klemmzungen geklemmt. Die Klemmung der Leitungskabel 327 in den Paaren 225 von Klemmzungen erfolgt dabei in ähnlicher Weise wie die zuvor beschriebene Klemmung der Leiterplatte 145 in den Paaren 220 von Klemmzungen. Die elektrischen Leiter der Kabel werden zwischen den Klemmzungen 225 geklemmt, welche zusätzlich schneidend ausgebildet sein können, um in den Leiter formschlüsslg einzugreifen.

Zur wasserdichten Verbindung des Bodenteils 100 mit dem Deckel 105 ist entlang des Fügebereichs des Bodenteils 100 eine Dichtung 330 aus einem elastischen Kunststoff angespritzt. Diese Dichtung 330 und die Wandungen 290, 295 des Klemmhalters 280 für den Kondensator 285 sind dabei gemeinsam aus demselben elastischen Kunststoff als zweite Komponente im Zweikomponenten-Spritzgießen gefertigt, wobei das Gehäuse 65 aus der ersten Komponente gebildet ist.

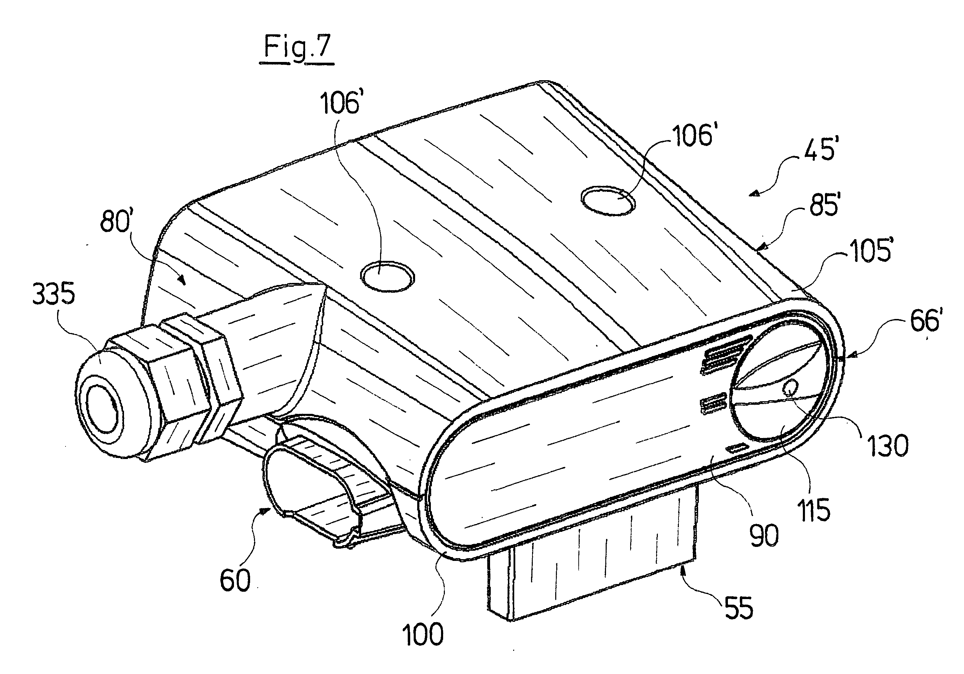

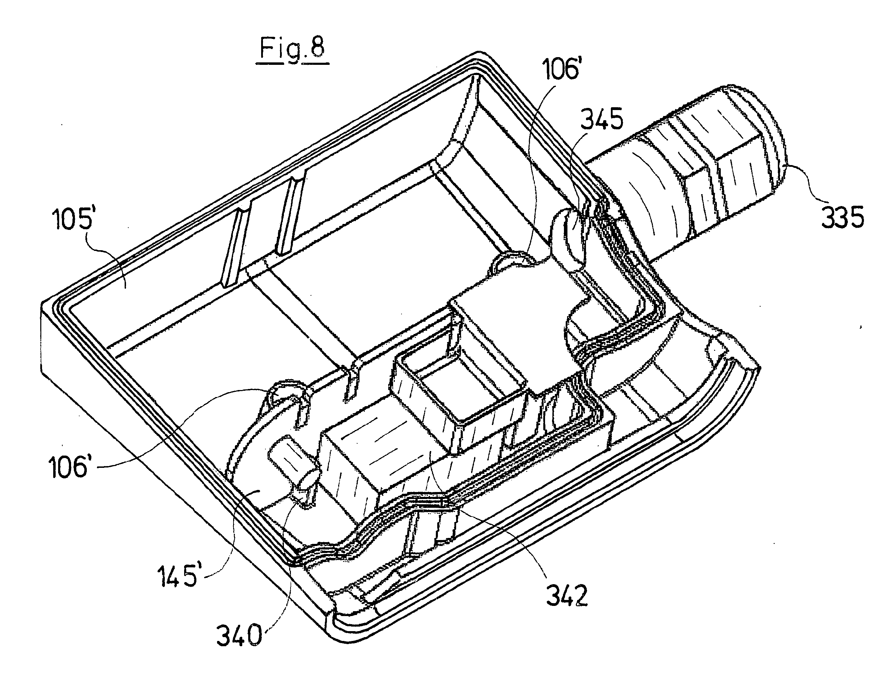

Der zuvor beschriebene Klemmenkasten 45 ist Teil eines Klemmenkastensystems, welcher neben dem zuvor beschriebenen Klemmenkasten 45 einen zweiten Deckel 105' aufweist, der eine zusätzliche Kabeldurchführung 335 umfasst (Fig, 7 und 8). Wie in Fig. 7 dargestellt, lässt sich dieser zusätzliche zweite Deckel 105' mit dem Bodenteil 100 zu einem vom Gehäuse 65 verschiedenen Gehäuse 65' eines erweiterten Klemmenkastens 45' zusammenfügen. Zusätzlich zu der Kabeldurchführung 335 weist der zweite Deckel 105' eine eigene, zweite Leiterplatte 145' auf, die an die Stelle der ersten Leiterplatte 145 tritt, wenn die Deckel 105, 105' ausgetauscht werden. Dazu sind sowohl die Leiterplatte 145 in dem Deckel 105 bzw. die Leiterplatte 145' in dem zweiten Deckel 105' wie in Fig. 8 dargestellt über Befestigungsmittel 340 fest angebracht. Indem ein Deckel 105 bzw, 105' auf das Bodenteil 100 gesetzt wird, gelangt gleichzeitig die Leiterplatte 145 bzw. 145' mit den Paaren 220 von Klemmzungen 236, 237 des Bodenteils 100 wie zuvor beschrieben in Kontakt. Entsprechend wird durch einen Wechsel des Deckels 105 bzw. 105' die Leiterplatte 145 bzw, 145' ausgewechselt. Dabei weist zudem die zweite Leiterplatte 145' einen gegenüber der ersten Leiterplatte 145 geänderten Funktionsumfang auf. So ist auf der zweiten Leiterplatte 145' ein steuerbarer Schalter, d. h. ein Relais 342, angebracht, dessen Steuerkontakt mit dem elektrischen Steckkontaktbereich zum Anschluss des Elektromotors 55 verbunden ist und dessen Schaltkontakte mit Kabeln (in der Zeichnung nicht dargestellt) verbunden sind, die durch die Durchführung 335 sowie eine Durchführung 345 des zweiten Deckels 105' geführt sind. Dabei schaltet der steuerbare Schalter auf der zweiten Leiterplatte 145' ein zweites Pumpenaggregat (in der Zeichnung nicht dargestellt) über die durch die Durchführungen 335, 345 geführten Kabel, z. B. wenn der Elektromotor 32 keinen elektrischen Strom erhält, ein zweites Pumpenaggregat (in der Zeichnung nicht dargestellt).

### Bezugszeichenliste

- 5: - Pumpenaggregat
- 10: - Kreiselpumpe
- 32: - Elektromotor
- 40: - Stator
- 45, 45': - Klemmenkasten
- 50: - Elektrische Leitung
- 55: - Elektrischer Steckkontaktbereich
- 60: - Elektrischer Steckkontaktbereich
- 65, 65': - Gehäuse des Klemmenkastens 45. 45'
- 70: - Oberseite
- 75: - Unterseite
- 80: - Kurze Schmalseite
- 85: - Kurze Schmalseite
- 90: - Vorderseite
- 95: - Rückseite
- 100: - Bodenteil
- 105, 105': - Deckel
- 105: - Durchführungen
- 108: - Löcher
- 110: - Drehschalter
- 114: - Stirnfläche des Drehkörpers 115
- 115: - Drehkörper
- 116: - Mantelfläche des Drehkörpers 115
- 117: - Aufnahme
- 120: - Markierungen
- 125: - Markierungen
- 130: - Leuchtanzeige
- 135: - Leuchtdiode
- 140: - Welle
- 141: Stirnseite der Aufnahme 117
- 142: - Durchführung für die Welle 140
- 145: - Leiterplatte
- 150: - Vorderseite der Leiterplatte 145
- 152: - Rückwärtige Flachseite der Leiterplatte 145
- 155: - Feststehender elektrischer Schaltkontakt
- 160, 165, 170: - Feststehender elektrischer Schaltkontakt
- 172: - Anlagefläche
- 175: - Beweglicher elektrischer Schaltkontakt
- 176: - Beweglicher elektrischer Schaltkontakt
- 178: - Leiterbahn
- 180: - Leiterbahnsystem
- 185: - Einzelne Leiterbahnen
- 190: - Gruppe von elektrischen Kontakten
- 195: - Gruppe von elektrischen Kontakten
- 200: - Erdungselement
- 205: - Kontaktfläche
- 210: - Durchführung
- 215: - Bodenfläche
- 220: - Paar federnder Klemmzungen zur Klemmung der Leiterplatte 145
- 225: - Paare federnder Klemmzungen
- 230: - Modul
- 235: - Kunststoff
- 236: - Klemmzunge
- 237: - Klemmzunge
- 238: - federnde Lasche
- 240: - Schmalseite der Leiterplatte 145
- 250: - Ende der Klemmzungen
- 255: - Vorsprung
- 260: - Kontaktflächen
- 265: - Kontaktflächen
- 270: - Rundung
- 280: - Klemmhalter
- 285: - Kondensator
- 290: - Wandung
- 295: - Wandung
- 300: - Gemeinsame Scheitelkante
- 305: - Klemmfläche
- 310: - Klemmfläche
- 315: - Rückwand des Bodenteils 100
- 320: - Längsachse des Kondensators 285
- 325: - Haltestange
- 327: - Leitungskabel
- 330: - Dichtung
- 335: - Kabeldurchführung
- 340: - Befestigungsmittel
- 342: - Relais
- 345: - Kabeldurchführung

## Patentansprüche

1. Klemmenkasten zum elektrischen Anschluss an einen Elektromotor, insbesondere eine Umwälzpumpe, umfassend zumindest eine Wandung (215) und zumindest eine Leiterplatte (145), wobei der Klemmenkasten (45) an der Wandung (215) zumindest einen elektrischen Kontakt (220) zur Verbindung mit der Leiterplatte (145) aufweist, **dadurch gekennzeichnet, dass** der elektrische Kontakt als Klemmelement (220) zur lösbaren Klemmung der mit ihren Flachseiten (150,152) senkrecht zu dieser Wandung (215) orientierten Leiterplatte (145) ausgebildet ist, wobei das Klemmelement (220) als ein Paar (220) federnder Klemmzungen (236, 237) ausgebildet ist, welche sich senkrecht von der Wandung (215) fortstrecken, und mittels welchen die Leiterplatte (145) an ihren Flachseiten (150, 152) geklemmt ist.

2. Klemmenkasten nach Anspruch 1, **dadurch gekennzeichnet, dass** die Leiterplatte (145) auf zumindest einer ihrer Flachseiten (150,152) zumindest einen elektrischen Kontakt (265) zur Verbindung mit dem Klemmelement (220) aufweist, welcher nah einer Seitenkante (240) der Leiterplatte (145) angeordnet ist.

3. Klemmenkasten nach einem der vorhergehenden Ansprüche, **dadurch gekennzeichnet, dass** das Klemmelement (220) in das Gehäuse (65) des Klemmenkastens (65) eingegossen ist.

4. Klemmenkasten nach einem der vorhergehenden Ansprüche, **dadurch gekennzeichnet, dass** das Klemmelement (220) Teil eines Leiterbahnsystems (180) ist, welches in das Gehäuse (65) des Klemmenkastens (45) eingegossen ist.

5. Klemmenkasten nach Anspruch 4, **dadurch gekennzeichnet, dass** das Leiterbahnsystem (180) zumindest eine der nachfolgenden Komponenten aufweist:
einen elektrischen Steckkontaktbereich (190) zum Anschluss des Elektromotors (32),
einen elektrischen Steckkontaktbereich (195) zum Anschluss an eine Spannungsquelle,
einen feststehenden elektrischen Kontakt (155, 160, 165, 170) eines Bedienschalters (110),
einen elektrischen Kontakt zum Anschluss eines Kondensators,
ein Erdungselement (200).

6. Klemmenkasten nach einem der vorhergehenden Ansprüche, **dadurch gekennzeichnet, dass** der Klemmenkasten (45) eine Haltevorrichtung (280) zur Klemmung eines Kondensators (285) aufweist, welche aus einem elastischen Kunststoff ausgebildet ist.

7. Klemmenkasten nach Anspruch 6, **dadurch gekennzeichnet, dass** der Klemmenkasten (45) einen ersten Gehäuseteil (100) und einen von diesem lösbaren Deckel (105) mit einer zwischenliegenden Dichtung (330) aufweist, und dass die Dichtung (330) und die Haltevorrichtung (280) aus demselben Material und gemeinsam mit dem ersten Gehäuseteil (100) des Klemmenkastens (45) als Mehrkomponenten-Spritzgussteil gebildet sind.

8. Klemmenkasten nach einem der vorhergehenden Ansprüche, **dadurch gekennzeichnet, dass** der Klemmenkasten (45) einen ersten Gehäuseteil (100) und einen von diesem lösbaren Deckel (105) aufweist und die Leiterplatte (145) an dem Deckel (105) befestigt ist.

9. Klemmenkasten nach einem der vorhergehenden Ansprüche, **dadurch gekennzeichnet, dass** der Klemmenkasten (45) einen ersten Gehäuseteil (100) und einen von diesem lösbaren Deckel (105) aufweist und an dem Deckel (105) zumindest ein elektrischer Kontakt gemeinsam mit zumindest einer Leiterbahn angeordnet, vorzugsweise in den Deckel (105) eingegossen ist.

10. Klemmenkasten nach einem der vorhergehenden Ansprüche, **dadurch gekennzeichnet, dass** der Klemmenkasten (45) einen ersten Gehäuseteil (100) und einen von diesem lösbaren Deckel (105) aufweist und an dem Deckel (105) zumindest eine Kabeldurchführung (345) und/oder ein elektrischer Steckkontakt angeordnet ist.

11. Klemmenkasten nach einem der vorhergehenden Ansprüche, **dadurch gekennzeichnet, dass** das Klemmelement (220) für die Leiterplatte an einem Gehäuseteil (100) angeordnet ist, welcher zum Anschluss an den Elektromotor (32) vorgesehen ist.

12. Klemmenkasten nach einem der vorhergehenden Ansprüche, **dadurch gekennzeichnet, dass** die Leiterplatte (145) einen steuerbaren Schalter (342) aufweist, umfassend zumindest einen Steuerkontakt, welcher mit einem elektrischen Steckkontaktbereich (190) zum Anschluss des Elektromotors (32) verbunden ist, und zumindest einen Schaltkontakt, welcher mit einem elektrischen Kontaktbereich des Klemmenkastens verbunden ist.

13. Klemmenkastensystem mit einem Klemmenkasten nach einem der vorhergehenden Ansprüche, **dadurch gekennzeichnet, dass** es zumindest zwei unterschiedliche Leiterplatten (145, 145') aufweist, welche wahlweise in das zumindest eine Klemmelement (220) des Klemmenkastens (45) einsetzbar sind.

14. Klemmenkastensystem mit einem Klemmenkasten nach einem der Ansprüche 1 bis 13, **dadurch gekennzeichnet, dass** es zumindest zwei unterschiedliche mit einem Gehäuseteil (100) des Klemmenkastens (45) wahlweise verbindbare Deckel (105,105') umfasst.

15. Pumpenaggregat, insbesondere ein Umwälzpumpenaggregat, **dadurch gekennzeichnet, dass** es einen Klemmenkasten (45) oder ein Klemmenkastensystem nach einem der vorhergehenden Ansprüche aufweist.

## Claims

1. A terminal box for the electrical connection to an electric motor, in particular of a circulation pump, comprising at least one wall (215) and at least one circuit board (145), wherein the terminal box (45) on the wall (215) comprises at least one electrical contact (220) for connection to the circuit board (145), **characterised in that** the electrical contact is designed as a clamping element (220) for the releasable clamping of the circuit board (145) which is orientated with its flat sides (150, 152) perpendicularly to this wall (215), wherein the clamping element (220) is designed as a pair (220) of resilient clamping tongues (236, 237) which extend perpendicularly from the wall (215) and by way of which the circuit board (145) is clamped on its flat sides (150, 152).

2. A terminal box according to claim 1, **characterised in that** the circuit board (145) on at least one of its flat sides (150, 152) comprises at least one electrical contact (265) for connection to the clamping element (220), said contact being arranged close to a side edge (240) of the circuit board (145).

3. A terminal box according to one of the preceding claims, **characterised in that** the clamping element (220) is moulded into the housing (65) of the terminal box (65).

4. A terminal box according to one of the preceding claims, **characterised in that** the clamping element (220) is part of a strip conductor system (180) which is moulded into the housing (65) of the terminal box (45).

5. A terminal box according to claim 4, **characterised in that** the strip conductor system (180) comprises at least one of the following components:
an electrical plug-in contact region (190) for connection of the electric motor (32),
an electrical plug-in contact region (195) for the connection to a voltage source,
a stationary electrical contact (155, 160, 165, 170) of an operating switch (110),
an electric contact for the connection of a capacitor,
an earthing element (200).

6. A terminal box according to one of the preceding claims, **characterised in that** the terminal box (45) comprises a holding device (280) for clamping a capacitor (285), said holding device being formed of an elastic plastic.

7. A terminal box according to claim 6, **characterised in that** the terminal box (45) comprises a first housing part (100) and a cover (105) which is releasable from this, with a seal (330) lying therebetween, and that the seal (330) and the holding device (280) are formed from the same material and together with the first housing part (100) of the terminal box (45) are formed as a multi-component injection moulding part.

8. A terminal box according to one of the preceding claims, **characterised in that** the terminal box (45) comprises a first housing part (100) and a cover (105) which can be released from this, and the circuit board (145) is fastened on the cover (105).

9. A terminal box according to one of the preceding claims, **characterised in that** the terminal box (45) comprises a first housing part (100) and a cover (105) which can be released from this, and at least one electrical contact together with at least one strip conductor is arranged on the cover (105), preferably is moulded into the cover (105).

10. A terminal box according to one of the preceding claims, **characterised in that** the terminal box (45) comprises a first housing part (100) and a cover (105) which can be released from this, and at least one cable lead-through (345) and/or an electrical plug-in contact is arranged on the cover (105).

11. A terminal box according to one of the preceding claims, **characterised in that** the clamping element (220) for the circuit board is arranged on a housing part (100), which is provided for connection onto the electric motor (32).

12. A terminal box according to one of the preceding claims, **characterised in that** the circuit board (145) comprises a controllable switch (342), comprising at least one control contact, which is connected to an electric plug-in contact region (190) for the connection of the electric motor (32), and at least one switch contact, which is connected to an electrical contact region of the terminal box.

13. A terminal box system with a terminal box according to one of the preceding claims, **characterised in that** it comprises at least two different circuit boards (145, 145') which can be selectively inserted into the at least one clamping element (220) of the terminal box (45).

14. A terminal box system with a terminal box according to one of the claims 1 to 13, **characterised in that** it comprises at least two different covers (105, 105') which can be selectively connected to a housing part (100) of the terminal box (45).

15. A pump assembly, in particular a circulation pump assembly, **characterised in that** it comprises a terminal box (45) or a terminal box system according to one of the preceding claims.

## Revendications

1. Boîte à bornes destinée à la connexion électrique à un moteur électrique, en particulier à une pompe de circulation, comprenant au moins une paroi (215) et au moins une carte de circuits imprimés (145), dans laquelle la boîte à bornes (45) présente, sur la paroi (215), au moins un contact électrique (220) destiné à la connexion avec la carte de circuits imprimés (145), **caractérisée en ce que** le contact électrique est conçu en tant qu'élément de serrage (220) destiné à serrer de façon démontable la carte de circuits imprimés (145) orientée par ses côtés plats (150, 152) perpendiculairement à cette paroi (215), l'élément de serrage (220) étant exécuté en tant que paire (220) de languettes de serrage élastiques (236, 237) qui se prolongent perpendiculairement depuis la paroi (215) et au moyen desquelles la carte de circuits imprimés (145) est serrée au niveau de ses côtés plats (150, 152).

2. Boîte à bornes selon la revendication 1, **caractérisée en ce que** la carte de circuits imprimés (145) présente sur au moins un de ses côtés plats (150, 152) au moins un contact électrique (265) destiné à la liaison avec l'élément de serrage (220), lequel est agencé près d'un bord latéral (240) de la carte de circuits imprimés (145).

3. Boîte à bornes selon l'une des revendications précédentes, **caractérisée en ce que** l'élément de serrage (220) est coulé dans le boîtier (65) de la boîte à bornes (65).

4. Boîte à bornes selon l'une des revendications précédentes, **caractérisée en ce que** l'élément de serrage (220) est une partie d'un système de pistes conductrices (180) qui est coulé dans le boîtier (65) de la boîte à bornes (45).

5. Boîte à bornes selon la revendication 4, **caractérisée en ce que** le système de pistes conductrices (180) présente au moins l'un des composants suivants :
une région électrique à contact enfichable (190) destinée à la connexion au moteur électrique (32),
une région électrique à contact enfichable (195) destinée à la connexion à une source de tension,
un contact électrique fixe (155, 160, 165, 170) d'un commutateur de commande (110),
un contact électrique destiné à la connexion d'un condensateur,
un élément de mise à la terre (200).

6. Boîte à bornes selon l'une des revendications précédentes, **caractérisée en ce que** la boîte à bornes (45) présente un dispositif de retenue (280) destiné au serrage d'un condensateur (285) et qui est fait d'une matière plastique élastique.

7. Boîte à bornes selon la revendication 6, **caractérisée en ce que** la boîte à bornes (45) présente une première partie de boîtier (100) et un couvercle (105) pouvant en être détaché et qui est muni d'un joint d'étanchéité (330) placé en interposition, et **en ce que** le joint d'étanchéité (330) et le dispositif de retenue (280) sont faits du même matériau et constitués par une pièce multi-composants moulée par injection conjointement à la première partie de boîtier (100) de la boîte à bornes (45).

8. Boîte à bornes selon l'une des revendications précédentes, **caractérisée en ce que** la boîte à bornes (45) présente une première partie de boîtier (100) et un couvercle (105) pouvant en être détaché, et **en ce que** la carte de circuits imprimés (145) est fixée au couvercle (105).

9. Boîte à bornes selon l'une des revendications précédentes, **caractérisée en ce que** la boîte à bornes (45) présente une première partie de boîtier (100) et un couvercle (105) pouvant en être détaché et **en ce qu'**au niveau du couvercle (105) est agencé au moins un contact électrique conjointement à au moins un circuit conducteur, de préférence coulé dans le couvercle (105).

10. Boîte à bornes selon l'une des revendications précédentes, **caractérisée en ce que** la boîte à bornes (45) présente une première partie de boîtier (100) et un couvercle (105) pouvant en être détaché, et **en ce qu'**au niveau du couvercle (105) est/sont agencé(s) au moins une traversée de câble (345) et/ou un contact électrique enfichable.

11. Boîte à bornes selon l'une des revendications précédentes, **caractérisée en ce que** l'élément de serrage (220) de la carte de circuits imprimés est agencé au niveau d'une partie de boîtier (100) qui est prévue pour la connexion au moteur électrique (32).

12. Boîte à bornes selon l'une des revendications précédentes, **caractérisée en ce que** la carte de circuits imprimés (145) présente un commutateur pouvant être commandé (342) qui comprend au moins un contact de commande, lequel est relié à une région électrique de contact enfichable (190) destinée à la connexion du moteur électrique (32), et au moins un contact de commutation qui est relié à une région électrique de contact de la boîte à bornes.

13. Système de boîte à bornes comprenant une boîte à bornes selon l'une des revendications précédentes, **caractérisé en ce qu'**il présente au moins deux cartes de circuits imprimées différentes (145, 145') qui peuvent être insérées au choix dans le au moins un élément de serrage (220) de la boîte à bornes (45).

14. Système de boîte à bornes comprenant une boîte à bornes selon l'une des revendications 1 à 13, **caractérisé en ce qu'**il comprend au moins deux couvercles différents (105, 105') qui peuvent être assemblés au choix à une partie de boîtier (100) de la boîte à bornes (45).

15. Groupe motopompe, en particulier groupe motopompe de circulation, **caractérisé en ce qu'**il présente une boîte à bornes (45) ou un système de boîte à bornes selon l'une des revendications précédentes.
